# EUROPÄISCHE PATENTSCHRIFT

(11) **EP 3 223 111 B1**
(45) Veröffentlichungstag und Bekanntmachung des Hinweises auf die Patenterteilung: **15.09.2021**
(21) Anmeldenummer: 17165982.4
(22) Anmeldetag: 07.10.2013
(51) Int. Cl.: G06F 1/16

(54) **SCHUTZEINRICHTUNG FÜR EIN BEDIENGERÄT**
PROTECTION DEVICE FOR AN OPERATOR DEVICE
DISPOSITIF DE PROTECTION POUR UN APPAREIL DE COMMANDE

(30) Priorität: 13.11.2012 DE 102012220693
(43) Veröffentlichungstag der Anmeldung: 27.09.2017
(62) Teilanmeldung aus: 13777232.3
(73) Patentinhaber: TRUMPF Medizin Systeme GmbH + Co. KG, 07318 Saalfeld (DE)
(72) Erfinder: MARKA, Rudolf, 85737 Ismaning (DE); ÖZHAN, Serhan, 81379 München (DE)
(74) Vertreter: Prüfer & Partner mbB Patentanwälte · Rechtsanwälte

(56) Entgegenhaltungen:
- EP-A1- 2 180 773
- DE-A1-102008 020 968
- US-A- 6 082 535
- US-A1- 2001 002 725
- US-A1- 2002 195 910
- US-A1- 2007 247 793
- US-A1- 2012 008 880

## Beschreibung

Die Erfindung betrifft eine Schutzeinrichtung für ein Bediengerät, insbesondere eine Schutzeinrichtung für ein Bediengerät, das einen Touchscreen aufweist.

Es sind Schutzhüllen für ein Bediengerät mit einem Touchscreen bekannt, die das Bediengerät vollständig umschließen, um das Bediengerät vor Spritzwasser zu schützen. Das Patent US 7,495,895 B2 zeigt beispielsweise eine Schutzabdeckung, die im Bereich des Touchscreens eine dünne flexible Membran aufweist, durch die hindurch der Touchscreen bedient wird.

Dabei besteht jedoch das Problem, dass das Bediengerät dadurch nicht gegen Schäden geschützt ist, die durch einen Herunterfallen hervorgerufen werden. Die Schutzabdeckung ist zudem aufwändig zu sterilisieren und bei der Verwendung der Schutzhülle, die als Einmalartikel verwendet werden kann, kann diese verrutschen, so dass die Bedienung des Touchscreens nicht mehr störungsfrei gewährleistet ist. Außerdem ist es erforderlich, dass die Schutzhülle eine Öffnung aufweist, durch die das Bediengerät in die Schutzhülle eingeführt werden kann, die wiederum spritzwassergeschützt verschließbar sein muss.

Weiterhin zeigt die Druckschrift WO 98/02170 eine Schutzhülle, die über einen Monitor gezogen wird, um ihn in einem sterilen Bereich betreiben zu können.

Die Druckschrift US 2002/0195910 A1 offenbart eine abdichtbare, transparente und flexible Membran für elektronische Touchscreens. Die Membran bildet ein Oberteil eines Schutzgehäuses.

Die Druckschrift US 2012/008880 A1 offenbart eine Schutzhülle aus flexiblem Material.

Der Erfindung liegt die Aufgabe zugrunde, eine Schutzeinrichtung für ein Bediengerät zur Verwendung in einer sterilen Umgebung bereitzustellen, die einfach, sicher und kostengünstig ist, und die eine Bedienung des Touchscreens nicht beeinträchtigt.

Die Aufgabe wird durch ein Schutzgehäuse gemäß Anspruch 1 sowie ein Verfahren gemäß Anspruch 6 gelöst. Weiterentwicklungen der Schutzeinrichtungen sind Gegenstand der abhängigen Ansprüche.

Die Erfindung ist in den Figuren 4 und 5 dargestellt und wird in den dazugehörigen Absätzen beschrieben. Die Ausführungsformen in den Figuren 1-3 fallen nicht in den Schutzbereich der Ansprüche.

Insbesondere zeigen:
- Fig. 1: eine Explosionszeichnung eines Schutzsystems mit optionalen Bauteilen;
- Fig. 2: ein Bediengerät mit einem Touchscreen mit einer Schutzhülle;
- Fig. 3: das Bediengerät von Fig. 2 mit einem Stoßschutzrahmen;
- Fig. 4: eine Querschnittsdarstellung eines Schutzgehäuses; und
- Fig. 5: eine Querschnittsdarstellung des Schutzsystems aus dem Schutzgehäuse und dem Stoßschutzrahmen.

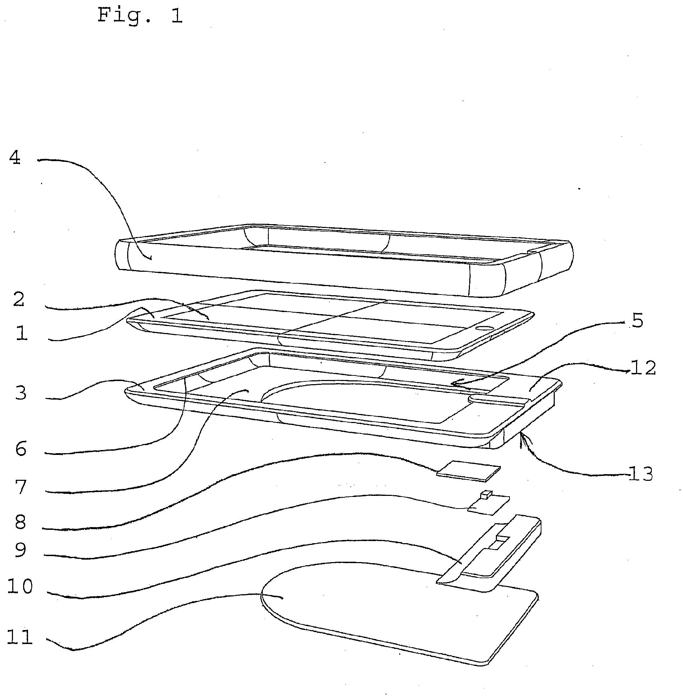

In Fig. 1 ist ein Schutzsystem zum Schützen eines Bediengeräts 1 mit einem Touchscreen 2 gezeigt. Der Touchscreen 2 des Bediengeräts 1 ist nicht zwingend erforderlich. Alternativ sind auch andere Bedienelemente, beispielsweise abgedichtete Schalter oder Schalter einer Folientastatur möglich. Wesentlich ist, dass kein Eindringen von verspritzten Flüssigkeiten zwischen einem Gehäuse des Bediengeräts und den Bedienelementen möglich ist.

Das Schutzsystem weist einen Stoßschutzrahmen 4, optional eine Schutzhülle 3, und optional eine später beschriebene Folienhülle auf.

Die Schutzhülle 3 ist schalenartig geformt und umschließt das Bediengerät 1 zumindest an den Seiten sowie an der Rückseite schalenförmig. Die Schutzhülle 3 weist eine Oberseite 12 und eine Unterseite 13 auf. Zudem weist die Schutzhülle 3 eine Aussparung 5, die ein Volumen des Bediengeräts 1 ausspart, mit einer inneren Fläche 7 auf, die im Wesentlichen an eine Rückseite des Bediengeräts 1 angepasst ist. Die Aussparung weist auf der Oberseite 12 eine Öffnung mit einem Rand 6 auf.

Die Aussparung 5 ist so in der Schutzhülle 3 vorgesehen, dass sie zumindest eine Fläche des Touchscreens 2 ausspart. An dem Rand 6 der Aussparung 5 bildet die Schutzhülle 3 mit dem Bediengerät 1 einen flüssigkeitsdichten Übergang, wie im Folgenden genauer erläutert wird.

Die Oberseite 12 weist zur Aussparung 5 hin einen Überhang über das Bediengerät 1 in Richtung der Aussparung 5 auf. Der Überhang ist so geformt, dass er in Richtung der Unterseite 13 zeigt. Der Rand 6 ist also näher an der inneren Fläche 7 angeordnet als ein verbleibender Bereich des Überhangs. Dadurch liegt nach einer Montage des Bediengeräts 1 in der Schutzhülle 3 der Rand 6 auf der Außenfläche des Bediengeräts 1 mit einer Vorspannung auf, wodurch der flüssigkeitsdichte Übergang gebildet wird.

Alternativ weist die Schutzhülle 3 an dem Rand 6 eine zu der inneren Fläche 7 hin vorstehende Rippe auf. Dadurch kann ebenfalls gewährleistet werden, dass die Schutzhülle 3 mit einer Vorspannung am Rand 6 auf der Außenfläche des Bediengeräts 1 aufliegt und der flüssigkeitsdichte Übergang gebildet wird.

In weiteren Alternativen sind eine Kombination der vorgenannten Maßnahmen oder beispielsweise ein Vorsehen von weiteren Dichtlippen oder anderen Dichtungsmaßnahmen möglich.

Durch die Schutzhülle 3 sind außerhalb einer Umgebung des Touchscreens 2 alle Bereiche des Bediengeräts abgedeckt.

Alternativ können weitere Aussparungen in der Schutzhülle 3 vorgesehen sein, die dann jeweils mit einem Verschluss flüssigkeitsdicht verschlossen sind.

Die Schutzhülle 3 ist aus Silikon hergestellt, kann aber alternativ auch aus anderen geeigneten elastischen Materialien hergestellt sein. Entscheidend ist, dass die Schutzhülle 3 nach der Montage des Bediengeräts 1 dieses umschließt, die Aussparung 5 zumindest die vollständige Fläche des Touchscreens 2 ausspart und der Rand 6 mit einer ausreichenden Vorspannung an der Außenfläche des Bediengeräts 1 abdichtend aufliegt. Die elastische Schutzhülle 3 ermöglicht einen Schutzhüllenaustausch durch den Benutzer. Alternativ kann die Schutzhülle 3 auch formstabil ausgeführt werden. In diesem Fall kann vorgesehen sein, dass die Schutzhülle 3 nicht bzw. nur von eingewiesenem Servicepersonal entfernt werden kann.

Zur Verbesserung des Schutzes besteht die Möglichkeit, den Stoßschutzrahmen 4 an der Schutzhülle 3 anzubringen, um das Bediengerät noch sicherer vor Beschädigungen, beispielsweise bei einem Fallen auf den Boden, zu schützen. Dazu weist der Stoßschutzrahmen 4 an einem Innenumfang eine Kontur auf, die komplementär zu einer Kontur einer umlaufenden Kante der Schutzhülle 3 geformt ist.

Der Stoßschutzrahmen 4 besteht aus Silikon und ist sterilisierbar oder alternativ aus einem anderen geeigneten sterilisierbaren Material. Der Stoßschutzrahmen 4 ist so geformt, dass er auf einer Vorderseite und einer Rückseite der Schutzhülle 3 einen Überhang bildet, so dass der Stoßschutzrahmen 4 das Bediengerät 1 umschließt, um sicher an der Schutzhülle 3 montierbar zu sein.

Alternativ ist der Stoßschutzrahmen 4 so geformt, dass er das Bediengerät 1 umschließt und auf einer Vorderseite und einer Rückseite des Bediengeräts 1 einen Überhang bildet.

Bei der Verwendung der nicht gezeigten Folienhülle, in die das in der Schutzhülle 3 befindliche Bediengerät 1 einbringbar ist, ist es günstig, den Stoßschutzrahmen 4 über der Folienhülle anzubringen, so dass eine sichere Befestigung der Folienhülle auf der Schutzhülle 3 gewährleistet werden kann, indem die Folienhülle zwischen dem Stoßschutzrahmen 4 und der Schutzhülle 3 eingeklemmt wird.

Die Folienhülle ist tütenförmig (alternativ: schlauchförmig oder ein Folienabschnitt) und weist eine Größe auf, so dass sie das Bediengerät 1, ggf. in der Schutzhülle 3, vollständig umschließt. Die Folienhülle ist sterilisierbar.

Die innen liegende Kontur des Stoßschutzrahmens 4 und die dazu komplementär umlaufende Kante der Schutzhülle 3 oder das Bediengerät 1 und die innere Kontur des Stoßschutzrahmens 4 sind in ihren Abmessungen so aufeinander abgestimmt, dass die Folienhülle dazwischen eingeklemmt werden kann. Dadurch ist es möglich, die Folienhülle über dem Touchscreen 2 straff zu halten, so dass dessen Bedienung störungsfrei möglich ist.

In einer optionalen Ausführungsform ist die Schutzhülle 3 mit einer Induktionsspule 8 versehen. Die Induktionsspule 8 ist über eine elektronische Steuerungseinrichtung 10 auf einer Platine 11 mit dem Bediengerät 1 verbunden und ermöglicht ein kontaktloses Aufladen eines Akkumulators des Bediengeräts 1. Dazu wird die Induktionsspule 8 in die Nähe einer weiteren nicht gezeigten Spule gebracht und über eine Induktivität die elektrisehe Energie kontaktlos zu dem Bediengerät 1 übertragen, ohne dass eine Aussparung in der Schutzhülle 3 erforderlich ist.

In einer weiteren alternativen Ausführungsform ist die Schutzhülle 3 zusätzlich oder alternativ mit einem Funksender und -empfänger versehen. Über den Funksender und -empfänger ist eine Ortung des Bediengeräts 1 möglich. Dadurch besteht die Möglichkeit, die räumliche Lage des Bediengeräts 1 zu den zu bedienenden Geräten zu erkennen und/oder die Anzeige des Touchscreen entsprechend anzupassen.

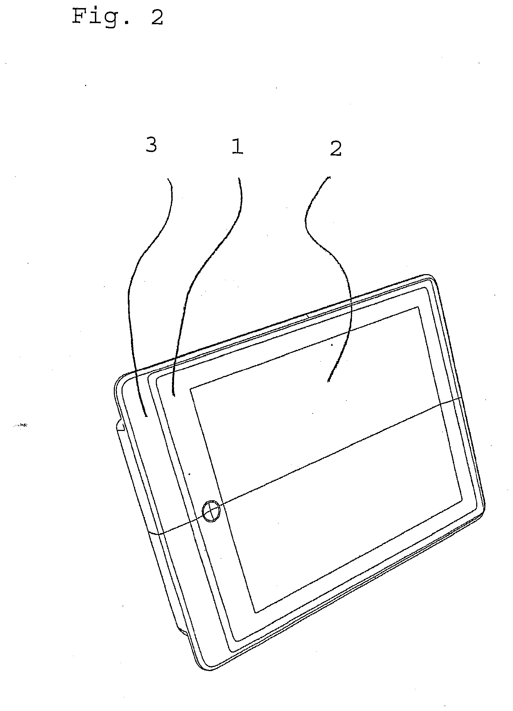

Fig. 2 zeigt das Bediengerät 1 mit dem Touchscreen 2 mit der Schutzhülle 3.

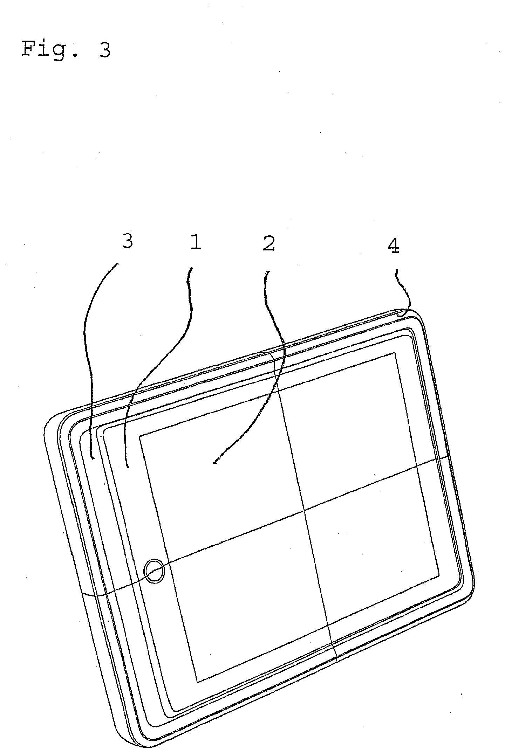

Fig. 3 ist eine Darstellung des Bediengeräts 1 mit der Schutzhülle 3 von Fig. 2, die zusätzlich mit dem Stoßschutzrahmen 4 versehen ist.

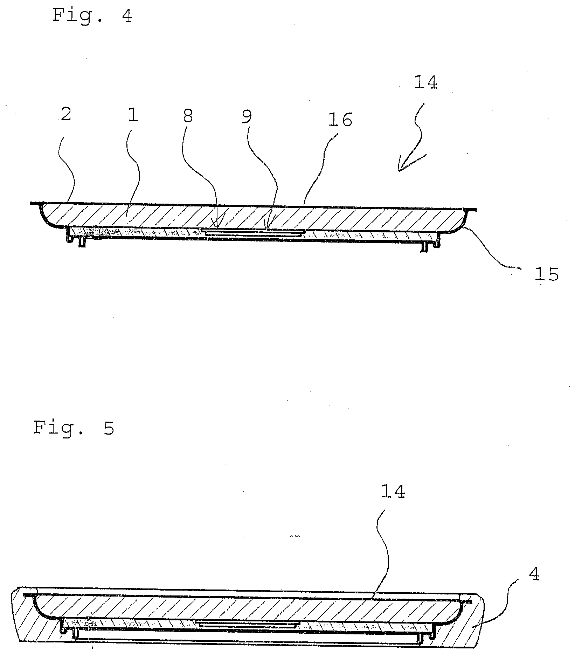

In Fig. 4 ist eine Querschnittsdarstellung eines Schutzgehäuses 14 gezeigt. Das Schutzgehäuse 14 weist ein Gehäuseunterteil 15 und ein Gehäuseoberteil 16 auf.

Das Gehäuseunterteil 15 ist ein Formteil aus einem plattenförmigen Kunststoffausgangsmaterial als eine Folie, die eine ausreichende Formanpassung an die Bedieneinheit bei Verbindung mit dem Gehäuseoberteil 16 erlaubt. Es weist eine Innenseite auf und wird fertigungstechnisch in eine Form gebracht, so dass die Innenseite an Bereiche von den Seiten und der Rückseite des Bediengeräts 1 so angepasst ist, dass eine relative Bewegung des Bediengeräts 1 in dem Schutzgehäuse 14 begrenzt wird. Das Gehäuseunterteil 15 ist nicht genau an das Bediengerät 1 angepasst, da ansonsten dadurch ein Einbringen von zusätzlichen Bauteilen oder Baugruppen nicht möglich wäre, und die Verwendung auch für ähnliche Bediengeräte nicht sichergestellt ist. Alternativ kann auch eine genaue Anpassung vorgesehen sein. Durch die Formgebung wird die Steifigkeit des Gehäuseunterteils 15 gegenüber dem Ausgangsmaterial erhöht, so dass es formstabil ist, also seine Form beibehält, wenn keine äußeren Kräfte darauf einwirken. Optional, in einer Ausführungsform die nicht von den Ansprüchen umfasst wird, ist das Gehäuseunterteil 15 aus einem Material hergestellt, das eine Steifigkeit und eine Wandstärke aufweist, so dass das Gehäuseunterteil 15 unelastisch ist, also nur mit einem großen Kraftaufwand geringfügig verformt werden kann. Dies stellt einen zusätzlichen Schutz gegen Beschädigungen des Bediengeräts 1 dar. Das Gehäuseunterteil 15 weist ferner eine umlaufende Fläche auf, an der das Gehäuseoberteil 16 durchgängig befestigt werden kann. Das Gehäuseoberteil 16 ist als eine transparente Folie (beispielsweise eine PE-Folie) ausgebildet, die so elastisch ist, dass eine gezielte Übertragung einer Betätigung des Gehäuseoberteils 16 auf den Touchscreen 2 möglich ist. Dadurch werden Betätigungen wie Tippen oder ein Darüberstreichen auf dem Gehäuseoberteil 16 durch den Touchscreen 2 erkannt, so dass der Touchscreen 2 des Bediengeräts 1 fehlerfrei bedient werden kann. Das Gehäuseoberteil 16 weist eine Größe und ein Material auf, die eine unlösbare Verbindung mit dem Gehäuseunterteil 15 ermöglichen. Im Gegensatz zum Gehäuseunterteil 15 ist das Gehäuseoberteil 16 hier zur Vereinfachung des Produktionsprozesses nicht als Formteil vorzusehen, sondern kann auf dem Gehäuseunterteil 15 als Flachmaterial zur weiteren Verarbeitung aufgebracht werden. Aus fertigungs- und produktionstechnischen Erwägungen ist es sinnvoll, das Gehäuseunterteil 15 und Gehäuseoberteil 16 aus dem gleichen Material, insbesondere auch mit der gleichen Wandstärke, vorzusehen. Für das Gehäuseunterteil 15 ergibt sich dann durch die Formgebung gegenüber dem Gehäuseoberteil 16 eine höhere Steifigkeit über die Geometrie.

Unter einer unlösbaren Verbindung wird eine Verbindung verstanden, die nur durch eine Zerstörung der Verbindung möglich ist. Die Verbindung wird beispielsweise durch Verschweißen oder Verkleben gebildet. Ein erneutes Erstellen einer zerstörten Verbindung ist ggf. möglich, sofern das Gehäuseunterteil 15 und das Gehäuseoberteil 16 beim Zerstören der Verbindung nicht beschädigt werden.

Durch die Ausbildung des Gehäuseunterteils 15 und des Gehäuseoberteils 16 und deren Verbindung ist das Schutzgehäuse flüssigkeitsdicht. Die Materialien des Gehäuseunterteils 15 und des Gehäuseoberteils 16 sind desinfektionsmittelbeständig, wodurch das Bediengerät 1 auch beispielsweise bei einer Wischdesinfektion geschützt ist.

Im Vergleich zu der lediglichen Verwendung einer Schutzfolie ist die Lebensdauer des Schutzgehäuses 14 wesentlich größer.

In dem Schutzgehäuse 14 sind optional ebenfalls die elektronischen Komponenten zum Orten, wie etwa der Funksender/-empfänger, und/oder zum kontaktlosen Aufladen des Akkumulators des Bediengeräts 1, wie etwa die Induktionsspule, vorgesehen.

Optional wird bei dem Verbinden des Gehäuseunterteils 15 und des Gehäuseoberteils 16 in dem Schutzgehäuse 14 ein Unterdruck erzeugt. Dieser Unterdruck ist so gewählt, dass er niedriger als ein weltweit bzw. an definierten Einsatzorten möglicher Luftdruck ist. Damit wird verhindert, dass unter jeglichen weltweiten Einsatzbedingungen, auch beispielsweise in Krankenhäusern in großen Höhen, verhindert wird, dass sich das Schutzgehäuse 14 aufwölbt.

Das Schutzgehäuse 14 wird wie folgend beschrieben hergestellt.

Das Gehäuseunterteil 15 wird ausgehend von dem plattenförmigen Ausgangsmaterial durch Vakuumtiefziehen in die dem Bediengerät 1 angepasste Form gebracht, so dass die Innenseite des Gehäuseunterteils 15 an die Bereiche von den Seiten und der Rückseite des Bediengeräts 1 angepasst ist. Hierbei wird auch die umlaufende Fläche zum durchgängigen Befestigen des Gehäuseoberteils 16 hergestellt. Alternativ sind auch andere Herstellungsverfahren, wie etwa Spritzgießen eines Kunststoffgranulats möglich.

Anschließend wird das Bediengerät 1 in das Gehäuseunterteil 15 eingebracht.

Optional werden die elektronischen Komponenten zum Orten und/ oder kontaktlosen Aufladen des Bediengeräts 1 in das Schutzgehäuse eingebracht.

Schließlich werden das Gehäuseoberteil 16 und das Gehäuseunterteil 15 zusammengeführt und an den Verbindungsstellen umfänglich flüssigkeitsdicht, insbesondere unlösbar, verbunden. Das unlösbare Verbinden erfolgt über Verkleben, Verschweißen oder einem anderen geeigneten Verfahren, z.B. Verbördeln.

Fig. 5 zeigt eine Querschnittsdarstellung des Schutzsystems aus dem Schutzgehäuse 14 und dem Stoßschutzrahmen 4. Der abnehmbare Stoßschutzrahmen 4 bietet einen zusätzlichen Schutz gegen Stöße, beispielsweise bei einem Herunterfallen des Bediengeräts 1 und verbessert eine Griffigkeit und Positionierbarkeit des Bediengeräts 1 auf einer Ladestation.

## Patentansprüche

1. Schutzgehäuse (14) für ein Bediengerät (1) mit einem Touchscreen (2) für ein Medizingerät, bestehend aus einem Gehäuseunterteil (15) und einem Gehäuseoberteil (16), wobei
das Gehäuseunterteil (15) formstabil ausgebildet ist, das Gehäuseunterteil (15) so geformt ist, dass eine Innenseite davon an Bereiche von Seiten und einer Rückseite des Bediengeräts (1) angepasst ist, und es eine umlaufende Fläche zum durchgängigen Befestigen des Gehäuseoberteils (16) aufweist,
das Gehäuseoberteil (16) als eine transparente Folie ausgebildet ist und so elastisch ist, dass eine gezielte Übertragung einer Betätigung des Gehäuseoberteils (16) auf den Touchscreen (2) möglich ist, und einen Bereich aufweist, an dem es an der umlaufenden Fläche des Gehäuseunterteils (15) befestigbar ist,
und das Gehäuseoberteil (16) mit dem Gehäuseunterteil (15) flüssigkeitsdicht verbunden ist, so dass das Bediengerät (1) durch das Schutzgehäuse (14) flüssigkeitsdicht umschlossen ist,
das Gehäuseoberteil (16) und das Gehäuseunterteil (15)
aus gleichem Material bestehen, und
die gleiche Wandstärke aufweisen, und
sich für das Gehäuseunterteil (15) durch eine Formgebung über eine Geometrie gegenüber dem Gehäuseoberteil (16) eine höhere Steifigkeit ergibt.

2. Schutzgehäuse (14) gemäß Anspruch 1, wobei das Gehäuseoberteil (16) und das Gehäuseunterteil (15) unlösbar miteinander verbunden sind.

3. Schutzgehäuse (14) gemäß Anspruch 1 oder 2, wobei das Schutzgehäuse (14) im Inneren einen Druck aufweist, der niedriger als ein im Einsatz vorgesehener Luftdruck ist.

4. Schutzgehäuse (14) gemäß einem der Ansprüche 1 bis 3, wobei es elektronische Komponenten zum Orten und/oder zum kontaktlosen Aufladen eines Akkumulators des Bediengeräts (1) aufweist.

5. Schutzgehäuse (14) gemäß Anspruch 4, wobei es eine Induktionsspule (8) zum kontaktlosen Aufladen des Akkumulators aufweist.

6. Verfahren zum Herstellen eines Schutzgehäuses (14) gemäß einem der Ansprüche 1 bis 5, das folgende Schritte aufweist:
- Bereitstellen des Gehäuseunterteils (15) als ein Formteil aus einem plattenförmigen Material, das durch Vakuumtiefziehen in eine dem Bediengerät (1) angepasste Form gebracht wird, so dass die Innenseite davon an die Bereiche von den Seiten und der Rückseite des Bediengeräts (1) anpassbar ist und eine umlaufende Fläche zum durchgängigen Befestigen des Gehäuseoberteils (16) vorsehbar ist;
- Einbringen des Bediengeräts (1) in das Gehäuseunterteil (15) oder Auflegen auf das Gehäuseoberteil (16);
- Zusammenführen des Gehäuseunterteils (15) und des Gehäuseoberteils (16) aus dem gleichen Material mit der gleichen Wandstärke, und Verbinden des Gehäuseunterteils (15) und des Gehäuseoberteils (16).

7. Verfahren gemäß Anspruch 6, wobei das Gehäuseunterteil (15) und das Gehäuseoberteil (16) unlösbar miteinander verbunden werden.

8. Verfahren gemäß Anspruch 6 oder 7 zum Herstellen eines Schutzgehäuses gemäß Anspruch 3, wobei während des Verbindens des Gehäuseunterteils (15) und des Gehäuseoberteils (16), ein Unterdruck innerhalb des Schutzgehäuses (14) erzeugt wird.

## Claims

1. Protection casing (14), for an operator device (1) having a touchscreen (2) for a medical apparatus, consisting of a lower casing part (15) and an upper casing part (16),
wherein the lower casing part (15) is designed to be dimensionally stable, the lower casing part (15) is formed such that an inside thereof is adapted to areas of sides and of a backside of the operator device (1), and it comprises a circumferential surface for continuously fixing the upper casing part (16),
the upper casing part (16) is designed as a transparent foil and it is as elastic as a targeted transmission of an operation of the upper casing part (16) to the touchscreen (2) is possible, and it comprises an area where it can be fixed to the circumferential surface of the lower casing part (15),
and the upper casing part (16) is joined to the lower casing part (15) in a liquid-tight manner so that the operator device (1) is enclosed by the protection casing (14) in a liquid-tight manner,
the upper casing part (16) and the lower casing part (15) consist of an identical material, and
have the same wall thickness, and
a higher rigidity for the lower casing part (15) with respect to the upper casing part (16) results from a shaping via a geometry.

2. Protection casing (14) according to claim 1, wherein the upper casing part (16) and the lower casing part (15) are joined to one another in a non-detachable manner.

3. Protection casing (14) according to claim 1 or 2, wherein, inside, the protection casing (14) has a pressure which is lower than an air pressure envisaged during use.

4. Protection casing (14) according to anyone of the claims 1 to 3, wherein it comprises electronic components for localizing and/or for charging an accumulator of the operator device (1) in a non-contact manner.

5. Protection casing (14) according to claim 4, wherein it comprises an induction coil (8) for charging the accumulator in a non-contact manner.

6. Method for manufacturing a protection casing (14) according to anyone of the claims 1 to 5, comprising the following steps:
- providing the lower casing part (15) as a molding of a plate-shaped material which is brought into a shape adapted to the operator device (1) by vacuum molding so that the inside thereof can be adapted to areas of the sides and of the backside of the operator device (1) and a surface for continuously fixing of the upper casing part (16) can be provided;
- inserting the operator device (1) into the lower casing part (15) or placing onto the upper casing part (16);
- bringing together the lower casing part (15) and the upper casing part (16) of the identical material having the identical wall thickness, and joining the lower casing part (15) and the upper casing part (16).

7. Method according to claim 6, wherein the lower casing part (15) and the upper casing part (16) are joined to one another in a non-detachable manner.

8. Method according to claim 6 or 7 for manufacturing a protection casing according to claim 3, wherein low pressure within the protection casing (14) is generated during the joining of the lower casing part (15) and the upper casing part (16).

## Revendications

1. Boîtier de protection (14) pour un appareil de commande (1) avec un écran tactile (2) pour un appareil médical, consistant en une partie inférieure de boîtier (15) et une partie supérieure de boîtier (16), où la partie inférieure de boîtier (15) est conçue indéformable, la partie inférieure de boîtier (15) est conformée de telle sorte qu'un côté interne de celle-ci est adapté à des zones de côtés et un côté dorsal de l'appareil de commande (1), et elle présente une surface périphérique pour la fixation continue de la partie supérieure de boîtier (16),
la partie supérieure de boîtier (16) est conçue comme un film transparent et est si élastique qu'une transmission ciblée d'un actionnement de la partie supérieure de boîtier (16) sur l'écran tactile (2) est possible, et présente une zone où elle peut être fixée à la surface périphérique de la partie inférieure de boîtier (15),
et la partie supérieure de boîtier (16) est jointe à la partie inférieure de boîtier (15) de manière étanche aux liquides, de sorte que l'appareil de commande (1) est entouré de manière étanche aux liquides par le boîtier de protection (14),
la partie supérieure de boîtier (16) et la partie inférieure de boîtier (15) consistent en le même matériau, et
présentent la même épaisseur de paroi, et
une plus grande rigidité pour la partie inférieure de boîtier (15) par rapport à la partie supérieure de boîtier (16) résulte d'une mise en forme par le biais d'une géométrie.

2. Boîtier de protection (14) selon la revendication 1, où la partie supérieure de boîtier (16) et la partie inférieure de boîtier (15) sont jointes l'une à l'autre de manière non séparable.

3. Boîtier de protection (14) selon la revendication 1 ou 2, où le boîtier de protection (14) présente à l'intérieur une pression qui est inférieure à une pression d'air prévue en service.

4. Boîtier de protection (14) selon l'une des revendications 1 à 3, où il présente des composants électroniques pour la localisation et/ou pour la charge sans contact d'un accumulateur de l'appareil de commande (1).

5. Boîtier de protection (14) selon la revendication 4, où il présente une bobine d'induction (8) pour la charge sans contact de l'accumulateur.

6. Procédé pour la fabrication d'un boîtier de protection (14) selon l'une des revendications 1 à 5, qui présente les étapes suivantes:
- fourniture de la partie inférieure de boîtier (15) sous la forme d'une pièce en un matériau en forme de plaque, qui est mise sous une forme adaptée à l'appareil de commande (1) par emboutissage profond sous vide, de sorte que le côté interne de celle-ci peut être adapté aux zones des côtés et du côté dorsal de l'appareil de commande (1) et une surface périphérique peut être prévue pour la fixation continue de la partie supérieure de boîtier (16);
- introduction de l'appareil de commande (1) dans la partie inférieure de boîtier (15) ou application sur la partie supérieure de boîtier (16);
- réunion de la partie inférieure de boîtier (15) et de la partie supérieure de boîtier (16) en le même matériau avec la même épaisseur de paroi, et jonction de la partie inférieure de boîtier (15) et de la partie supérieure de boîtier (16).

7. Procédé selon la revendication 6, où la partie inférieure de boîtier (15) et la partie supérieure de boîtier (16) sont jointes l'une à l'autre de manière non séparable.

8. Procédé selon la revendication 6 ou 7 pour la fabrication d'un boîtier de protection selon la revendication 3, où un vide est créé à l'intérieur du boîtier de protection (14) lors de la jonction de la partie inférieure de boîtier (15) et de la partie supérieure de boîtier (16).
